# EUROPEAN PATENT SPECIFICATION

(11) **EP 2 015 373 B1**
(45) Date of publication and mention of the grant of the patent: **09.11.2016**
(21) Application number: 08160004.1
(22) Date of filing: 09.07.2008
(51) Int. Cl.: H01L 33/40, H01L 33/42

(54) **Light emitting device**
Lichtemittierende Vorrichtung
Dispositif électroluminescent

(30) Priority: 10.07.2007 JP 2007180815; 02.07.2008 JP 2008173039
(43) Date of publication of application: 14.01.2009
(73) Proprietor: Toyoda Gosei Co., Ltd., Nishikasugai-gun, Aichi 452-8564 (JP)
(72) Inventor: Moriyama, Miki, Nishikasugai-gun Aichi 452-8564 (JP); Goshonoo, Koichi, Nishikasugai-gun Aichi 452-8564 (JP)
(74) Representative: TBK

(56) References cited:
- EP-A1- 1 298 461
- WO-A1-2006/073189
- US-A1- 2006 081 869
- FURUBAYASHI Y., HITOSUGI T.: "A transparent metal: Nb-doped anatase TiO2", APPLIED PHYSICS LETTERS, vol. 86, 252101, 13 June 2005 (2005-06-13) , pages 252101-1-252101-3, XP002697241, DOI: 10.1063/1.1949728

## Description

The present application is based on Japanese Patent Application Nos. 2007-180815 and 2008-173039 filed on July 10, 2007 and July 2, 2008, respectively, the entire contents of which are incorporated herein by reference.

### BACKGROUND OF THE INVENTION

### 1. FIELD OF THE INVENTION

The present invention relates to a light emitting device provided with a conductive reflection layer.

### 2. RELATED ART

Prior art which is related to this field of technology is disclosed in US 2006/0081869 A1 showing a flip-chip light-emitting element having a reflective electrode formed by multilayer coating.

JP-A 2006-120913 discloses a flip chip type group-III nitride compound semiconductor light emitting device in which a transparent conductive film is formed on a p-type contacting layer, a multilayer reflection film of a dielectric material and an electrode layer separately from the multilayer reflection film are formed on the transparent conductive film, and a metal layer is further formed on the multilayer reflection film.

Furthermore, JP-A 2006-121084 discloses a flip chip type group-III nitride compound semiconductor light emitting device in which an active layer is formed on a first type semiconductor layer, a second type semiconductor layer is formed on the active layer, a transparent conductive layer of AlGaInSnO system oxide is formed on the second type semiconductor layer, and a metal reflection layer is further formed on the transparent conductive layer.

The light emitting element in JP-A 2006-120913 operates such that light emitted from a light-emitting layer of the semiconductor light emitting device is reflected by the multilayer reflection film and the metal layer. Light reflected by the multilayer reflection film and the metal layer is radiated outside the semiconductor light emitting device, and it is possible to increase external quantum efficiency as compared to the case not having the multilayer reflection film or the metal layer.

The light emitting device of JP-A 2006-121084 is constructed such that the transparent conductive layer on the second type semiconductor layer has electrical conductivity, and therefore it is not necessary to form an electrode layer on the second type semiconductor layer separately from the transparent conductive layer. Furthermore, since the transparent conductive layer may be formed of multiple layers, it is possible to enhance reflectivity of the transparent conductive layer.

However, in the light emitting device of JP-A 2006-120913 , electric current does not flow through the multilayer reflection film of the dielectric material, and it is necessary to flow electric current to the p-type contacting layer through the electrode layer formed on the transparent conductive film separately from the multilayer reflection film. Therefore, a process of making the light emitting device becomes complicated. Furthermore, in the light emitting device of JP-A 2006-121084, the multiple conductive layers (or the multilayer reflection film) of AlGaInSnO system oxide are each formed of the same material, and therefore it is difficult to ensure a large refractive index difference among the multiple conductive layers.

### THE SUMMARY OF THE INVENTION

It is an object of the invention to efficiently extract light emitted from the light-emitting layer and to simplify a production process of the light emitting device by using a multilayer reflection layer composed of transparent conductive materials to be easily controlled in refractive index.
(1) According to one aspect of the invention, a light emitting device comprises: a light-emitting layer for emitting light by being supplied with power; and
   a reflection layer for reflecting the light emitted from the light-emitting layer, wherein the reflection layer comprises:
   a first conductive layer comprising titanium oxide (TiO₂) including an impurity, electrical conductivity, and transparency to the light emitted from the light-emitting layer; and
   a second conductive layer comprising an electrically conductive material having a refractive index smaller than that of the first conductive layer, and transparency to the light emitted from the light-emitting layer, the second conductive layer contacting the first conductive layer, wherein the power is supplied to the light-emitting layer through the first conductive layer and the second conductive layer, the impurity comprises Ta in a predetermined doping amount to the first conductive layer (300), the first conductive layer (300) comprises Ti₁₋ₓTaₓO₂ whose refractive index can be controlled according to the doping amount of Ta to the first conductive layer (300), the refractive index of the first conductive layer (300) is in a range from 2.5 to 2.8 according to the doping amount of Ta to the first conductive layer (300), and difference between the refractive index of the first conductive layer (300) and that of the second conductive layer (302) is set to be from 0.5 to 0.8.

In the above invention (1), the following modifications and changes can be made.
(i) The reflection layer comprises a structure in which a plurality of conductive unit layers comprising the first conductive layer and the second conductive layer contacting the first conductive layer are stacked.
(ii) The first conductive layer comprises a film thickness that is 1/(4n₁) of a wavelength of the light emitted from the light-emitting layer where n₁ is a refractive index of the first conductive layer, and
   the second conductive layer comprises a film thickness that is 1/(4n₂) of the wavelength of the light emitted from the light-emitting layer where n₂ is a refractive index of the second conductive layer.
(iii) The first conductive layer comprises a film thickness that is greater than 1/(4n₁) of a wavelength of the light emitted from the light-emitting layer where n₁ is a refractive index of the first conductive layer, and
   the second conductive layer comprises a film thickness that is greater than 1/(4n₂) of the wavelength of the light emitted from the light-emitting layer where n₂ is a refractive index of the second conductive layer.
(iv) The first conductive layer comprises a film thickness that is not more than 1.05 times of 1/(4n₁) of the wavelength of the light emitted from the light-emitting layer, and
   the second conductive layer comprises a film thickness that is not more than 1.05 times of 1/(4n₂) of the wavelength of the light emitted from the light-emitting layer.
(v) The reflection layer comprises a metal layer for reflecting the light emitted from the light-emitting layer to an opposite side of the light-emitting layer.
(vi) The electrically conductive material composing the second conductive layer comprises a refractive index of not more than 2.2.
(vii) The electrically conductive material composing the second conductive layer comprises indium tin oxide (ITO).
(viii) The electrically conductive material composing the second conductive layer comprises zinc oxide (ZnO).

### Advantages of the invention

In the invention, by using a multilayer reflection layer composed of transparent conductive materials to be easily controlled in refractive index, light emitted from the light-emitting layer can be efficiently extracted outside the light emitting device and the production process of the light emitting device can be simplified.

### BRIEF DESCRIPTION OF THE DRAWINGS

Next, the present invention will be explained in more detail in conjunction with appended drawings, wherein:
**FIG.1** is a longitudinal sectional view showing a light emitting device in a first preferred embodiment of the invention;
**FIG.2** is an enlarged sectional view showing a reflection layer in the first embodiment;
**FIG.3** is a graph showing a change in refractive index depending on impurity concentration of a first conductive layer in the first preferred embodiment;
**FIG.4A** is a graph showing a reflectivity calculation result of the reflection layer composed of a material having a refractive index of **2.0** and a material having a refractive index of **2.1;**
**FIG.4B** is a graph showing a reflectivity calculation result of the reflection layer composed of a material having a refractive index of **2.0** and a material having a refractive index of **2.5;**
**FIG.4C** is a graph showing a reflectivity calculation result of the reflection layer composed of a material having a refractive index of **2.0** and a material having a refractive index of **2.8;**
**FIG.5** is a graph showing a reflectivity dependency on the number of pairs of a conductive unit layer when using materials different in refractive index;
**FIG.6** is a graph showing the number of pairs of the conductive unit layer required to have **99%** or more reflectivity of the reflection layer at a wavelength of **460**nm where a second conductive layer is formed of ITO;
**FIG.7** is a graph showing a total thickness of the reflection layer required to have **99%** or more reflectivity of the reflection layer at a wavelength of **460**nm where the reflection layer is formed by plural conductive unit layers and the second conductive layer is formed of ITO;
**FIG.8** is a reflection spectrum when the reflection layer is formed with the number of pairs of the conductive unit layer required to have 99% or more reflectivity of the reflection layer;
**FIG.9A** is a graph showing reflectivity dependency on wavelength of the reflection layer in modifications;
**FIG.9B** is a graph showing reflectivity dependency (S-wave) to light with a wavelength of **460**nm on incident angle of the reflection layer in the modifications;
**FIG.9C** is a graph showing reflectivity dependency (P-wave) to light with a wavelength of **460**nm on incident angle of the reflection layer in the modifications;
**FIG.10** is a graph showing the number of pairs of the conductive unit layer required to have **99%** or more reflectivity of the reflection layer when the second conductive layer is changed in refractive index;
**FIG.11** is a longitudinal sectional view showing a light emitting device in a second preferred embodiment of the invention;
**FIG.12** is a longitudinal sectional view showing a light emitting device in a third preferred embodiment of the invention;
**FIG.13** is a longitudinal sectional view showing a light emitting device in a fourth preferred embodiment of the invention; and
**FIG.14** is a longitudinal sectional view showing a light emitting device in a fifth preferred embodiment of the invention.

### DESCRIPTION OF THE PREFERRED EMBODIMENTS

### First embodiment

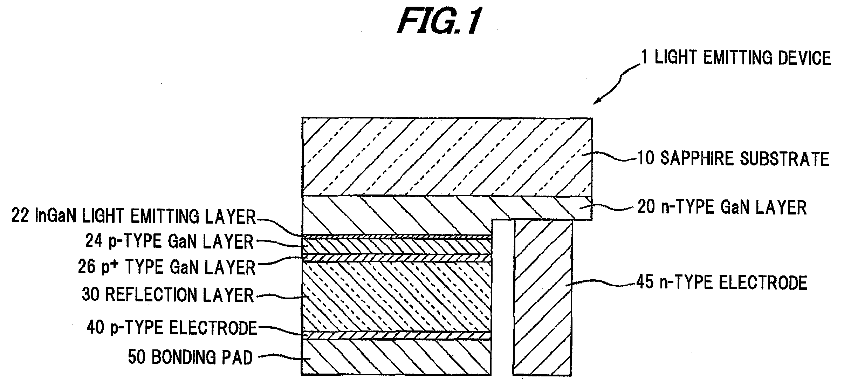

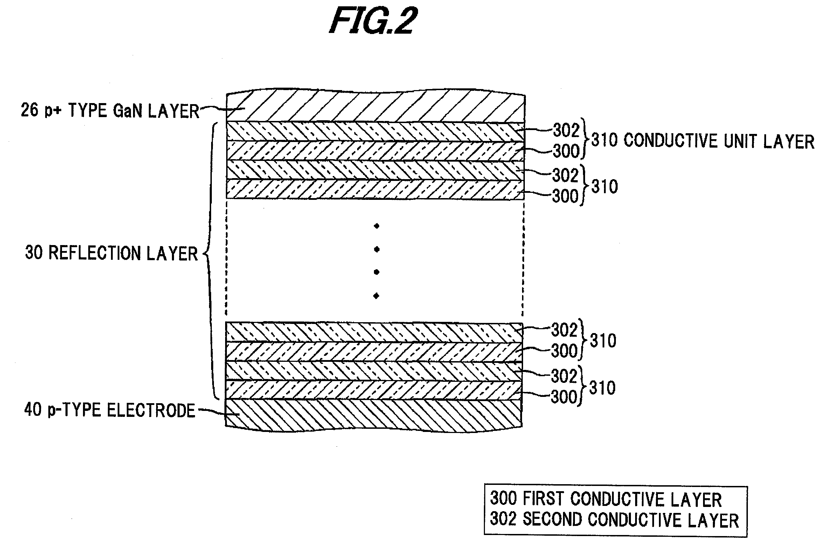

**FIG.1** shows a longitudinal sectional view of a light emitting device in the first preferred embodiment according to the present invention. Furthermore, **FIG.2** shows an enlarged longitudinal section of a reflection layer in the first preferred embodiment.

### Structure of light emitting device 1

A light emitting device **1** in the first preferred embodiment according to the present invention comprises a sapphire substrate **10,** a n-type GaN layer **20** formed on the sapphire substrate **10,** an InGaN light-emitting layer **22** formed on the n-type GaN layer **20,** a p-type GaN layer **24** formed on the InGaN light-emitting layer **22** and a p⁺ type GaN layer **26** formed on the p-type GaN layer **24** and having impurity concentration higher than the p-type GaN layer **24.**

Furthermore, the light emitting device **1** comprises a reflection layer **30** formed on the p⁺ type GaN layer **26,** an electrode for p-type **40** as a metal layer formed on the reflection layer **30,** a bonding pad **50** formed on the electrode for p-type **40** and an electrode for n-type **45** formed on the n-type GaN layer **20** exposed by partially removing from the p⁺ type GaN layer **26** to a part of the n-type GaN layer **20** by etching.

Here, the n-type GaN layer **20,** the InGaN light-emitting layer **22,** the p-type GaN layer **24** and the p⁺ type GaN layer **26** are of a group-III nitride compound semiconductor and formed by, for example, metal organic chemical vapor deposition (MOCVD).

For example, the n-type GaN layer **20** is doped with a predetermined amount of Si as an n-type dopant. Furthermore, the InGaN light-emitting layer **22** is formed so as to have a multiple quantum well structure composed of InₓGa₁₋ₓN/GaN. Furthermore, the p-type GaN layer **24** and the p⁺ type GaN layer **26** are each doped with a predetermined amount of Mg as a p-type dopant.

The light emitting device **1** in this embodiment thus structured is a light-emitting diode (LED) to emit light with a wavelength in the blue region. For example, the light emitting device **1** is a flip-chip blue light-emitting diode that emits light with a peak wavelength of **460**nm at forward voltage of **3.5**V and forward current of **20**mA. Furthermore, the light emitting device **1** is formed a substantially square (top view). The planar dimension of the light emitting device **1** is substantially **350**µm in vertical and horizontal dimensions, respectively.

As shown in **FIG.2****,** the reflection layer **30** has the structure that a second conductive layer **302** and a first conductive layer **300** are formed alternately and periodically on the p⁺ type GaN layer **26.** Namely, the first conductive layer **300** and the second conductive layer **302** contact each other, and one conductive unit layer **310** is formed as a pair of the second conductive layer **302** and the first conductive layer **300.** Further, the reflection layer **30** has the structure that plural conductive unit layers **310** are laminated on the p⁺ type GaN layer **26.** For example, the reflection layer **30** is a distributed Bragg reflector (DBR) composed of plural layers each formed of two materials different in refractive index.

Here, the first conductive layer **300** exhibits electrical conductivity by containing a predetermined concentration of Ta as an impurity and is mainly formed of titanium oxide (TiO₂) having transparency to light emitted from the InGaN light-emitting layer **22.** Specifically, the first conductive layer **300** is formed of electrically conductive Ti₁₋ₓTaₓO₂ doped with **3-5**% of Ta and having a refractive index of about **2.5.** Here, the resistivity of Ti₁₋ₓTaₓO₂ is **1x10⁻¹Ωcm** or less. The first conductive layer **300** has a film thickness which is **1**/(**4**n₁) of a wavelength of light emitted from the InGaN light-emitting layer **22** (n₁ is a refractive index of the first conductive layer **300).** For example, when a wavelength emitted from the InGaN light-emitting layer **22** is about **460**nm, the film thickness of the first conductive layer **300** is about **46**nm.

Furthermore, the second conductive layer **302** is formed of, for example, indium tin oxide (ITO) as an electrically conductive material. ITO forming the second conductive layer 302 has a refractive index smaller than TiO₂ forming the first conductive layer **300** (about **2.0**) and transparency to the light emitted from the InGaN light-emitting layer **22.** Then, the second conductive layer **302** has a film thickness which is **1/(4n₂)** of a wavelength of the light emitted from the InGaN light-emitting layer **22** (n₂ is a refractive index of the second conductive layer **302).** For example, when a wavelength emitted from the InGaN light-emitting layer **22** is about **460**nm, the film thickness of the second conductive layer **302** is about **57.5**nm.

Here, the number of the conductive unit layers **310** in the reflection layer **30** is determined such that the reflectivity of the reflection layer **30** with respect to wavelength of light emitted from the InGaN light-emitting layer **22** is to be a desired value. For example, in order to have about **100**% reflectivity of the reflection layer **30,** the reflection layer **30** is to have the fifteen to twenty conductive unit layers **310.**

The n-type electrode **45** formed on the n-type GaN layer **20** is formed, for example, of one or more than two selected from the group of Ti, Al, Pd, Pt, V, Ir and Rh or the like. The bonding pad **50** is formed, for example, of Ti, Ni and Au or the like.

The p-type electrode **40** as a metal layer in this embodiment is formed opposite the InGaN light-emitting layer **22** via the conductive unit layer **310** including the first conductive layer **300** and the second conductive layer **302.** The p-type electrode **40** is formed, for example, of Ag having **93%** reflectivity with respect to light (about **460**nm in wavelength) emitted from the InGaN light-emitting layer **22.**

Every layer from the n-type GaN layer **20** to the p⁺ type GaN layer **26** formed on the sapphire substrate **10** may be formed by molecular beam epitaxy (MBE) or halide vapor phase epitaxy (HVPE) or the like. For example, a buffer layer may be formed of AlN or GaN on the sapphire substrate **10,** and the n-type GaN layer **20** may be formed on the buffer layer. The quantum well structure of the InGaN light-emitting layer **22** can be a single quantum well structure. Alternatively, a bulk light-emitting layer may be used without the quantum well structure.

TiO₂ forming the first conductive layer **300** may be anatase-type or rutile-type. In terms of controlling the electrical conductivity, it is preferable to form the first conductive layer **300** using anatase-type TiO₂, and in terms of controlling the refractive index, it is preferable to form the first conductive layer **300** using rutile-type TiO₂. In order to control both the electrical conductivity and the refractive index, it is possible to form the first conductive layer **300** composed of anatase-type TiO₂ and rutile-type TiO₂. Also, it is possible to vary the refractive index of the first conductive layer **300** in a range from about **2.0** to about **2.8** according to the doping amount of Ta to the first conductive layer **300.** Therefore, it is possible to form the first conductive layer **300** by varying the doping amount of Ta to TiO₂ forming the first conductive layer **300** according to the refractive index of the material forming the second conductive layer **302** so as to set the difference between the refractive index of the first conductive layer **300** and that of the second conductive layer **302** to be from 0.5 to 0.8.

In a comparative example not covered by the invention, the impurity doped into the first conductive layer **300** may be Nb. When the impurity to be doped into the first conductive layer **300** is Nb, the first conductive layer **300** is Ti₁₋ₓNbₓO₂.

The second conductive layer **302** is preferably formed of an electrically conductive material having transparency to light emitted from the InGaN light-emitting layer **22** and also having the refractive index **of 2.2** or less so as to increase the refractive index difference from the first conductive layer **300.** For example, it is possible to form the second conductive layer **302** not only of ITO but also zinc oxide (ZnO). Furthermore, it is possible to form the conductive unit layer **310** including a conductive layer formed of another electrically conductive material exhibiting a different refractive index from the first conductive layer **300** and the second conductive layer **302.** Then, it is possible to control the number of conductive unit layers **310** forming the first conductive layer **300** to be an adequate number according to the desired reflectivity. Furthermore, it is possible to form the electrode for p-type **40** of a metal such as Al or Rh or the like which shows a predetermined reflectivity with respect to light emitted from the InGaN light-emitting layer **22.**

In this embodiment, the light emitting device **1** is an LED which emits light with a wavelength in the blue region, however, it may be an LED which emits light with a wavelength in the ultraviolet region, the violet region or the green region in other preferred embodiments. Furthermore, in the other preferred embodiments, the light emitting device **1** may be an LED composed of a group III-V compound semiconductor or a group II-IV compound semiconductor (for example, ZnO system, ZnSe system, GaAs system, GaP system or InP system). In this case, the film thicknesses of the first conductive layer **300** and the second conductive layer **302** which compose the reflection layer **30** are each formed according to wavelength of light emitted from a light-emitting layer. The planar dimension of the light emitting device **1** may be substantially 1mm in vertical and horizontal dimensions, respectively.

### Process of making light emitting device 1

Firstly, an epi-substrate is formed by epitaxially growing the group-III nitride compound semiconductor on the surface of the sapphire substrate **10** by MOCVD. Namely, the epi-substrate is formed by epitaxially growing the n-type GaN layer **20,** the InGaN light-emitting layer **22,** p-type GaN layer **24** and p⁺ type GaN layer **26** on the sapphire substrate **10 in** this order.

Then, a photoresist mask is formed by photolithography in a predetermined region of the p⁺ type GaN layer **26.** Then, etching is performed from the p⁺ type GaN layer **26** to a part of n-type GaN layer **20** except a part where the mask is formed. Then, the mask is removed. As a result, a shape exposing the surface of a part of the n-type GaN layer **20** is formed.

Then, for example, the reflection layer **30** is formed by repeatedly laminating the second conductive layer **302** and the first conductive layer **300** in this order on the p⁺ type GaN layer **26** by sputtering. It is also possible to form the reflection layer **30** by vacuum deposition such as electron beam vacuum deposition. In this embodiment, the conductive unit layer **310** including the first conductive layer **300** of TiO₂ and the second conductive layer **302** of ITO is laminated twenty layers.

Then, the electrode for p-type **40** is formed on the reflection layer **30** by vacuum deposition and a photolithographic technique. In the same way, the electrode for n-type **45** is formed on the n-type GaN layer **20** by vacuum deposition and photolithography. Then, the bonding pad **50** is formed on the electrode for p-type **40** by vacuum deposition and photolithography.

The light emitting device **1** formed by this process is mounted by flip-chip bonding at a predetermined position of a substrate of ceramic or the like in which a wiring pattern of a conductive material is formed in advance. Then, the packaged light emitting device **1** can be obtained by integrally sealing the light emitting device **1** mounted on the substrate with a sealant such as an epoxy resin or glass or the like. As an example, the sealant may include a phosphor that is exited by light with a predetermined wavelength and emits light with a different wavelength from the excitation light.

### Operation of light emitting device 1

Firstly, predetermined power supplied to the bonding pad **50** is inputted to the reflection layer **30** via the p-type electrode **40** from the bonding pad **50.** In this embodiment, since the first conductive layer **300** and the second conductive layer **302** composing the reflection layer **30** is conductive, the power inputted to the reflection layer **30** is then inputted to the p⁺ type GaN layer **26** via the first conductive layer **300** and the second conductive layer **302.** Namely, the reflection layer **30** has a role as an electrode for inputting power supplied from outside the light emitting device **1** to the InGaN light-emitting layer **22.**

Then, power supplied to the p⁺ type GaN layer **26** is inputted to the InGaN light-emitting layer **22** via the p-type GaN layer. The light-emitting layer **22** emits light at a predetermined wavelength by being supplied power. A part of light emitted from the light-emitting layer **22** is radiated outside the light emitting device **1** while directly passing through the n-type GaN layer **20** and the sapphire substrate **10.** On the other hand, a part of light emitted from the light-emitting layer **22** is radiated toward the reflection layer **30.** A part of light radiated toward the reflection layer **30** is then reflected toward the sapphire substrate **10** by the reflection layer **30** and is radiated outside the light emitting device **1** through the sapphire substrate **10.**

Here, depending on reflectivity exhibited by the reflection layer **30,** of light emitted from the light-emitting layer **22,** a part radiated toward the reflection layer **30** may reach the p-type electrode **40** while passing through the reflection layer **30.** Even in this case, light passing through the reflection layer **30** can be reflected toward the sapphire substrate **10** by the p-type electrode **40** and radiated outside the light emitting device **1.**

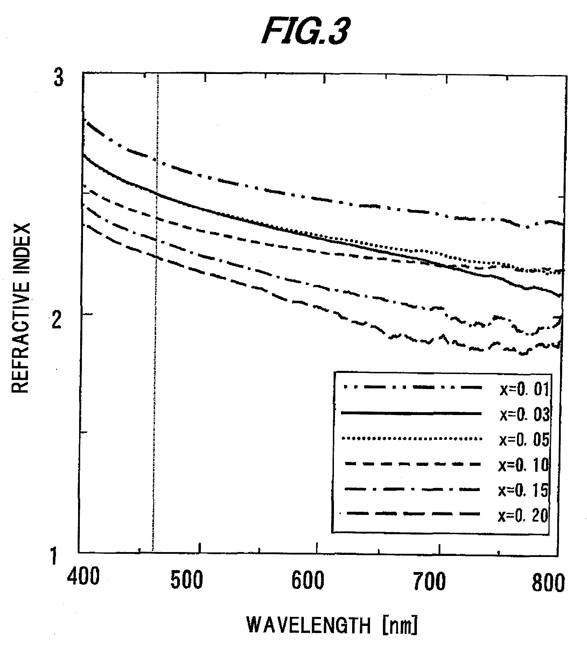

**FIG.3** shows a change in refractive index depending on impurity concentration of the first conductive layer in the first embodiment.

When TiO₂ is doped with Ta as impurity, it becomes Ti₁₋ₓTaₓO₂ according to the concentration of Ta doped. **FIG.3** shows a refractive index of Ti₁₋ₓTaₓO₂ with respect to light with a wavelength from **400**nm to **800**nm when x changes from **0.01** up to **0.2.** According as the concentration of doped Ta increases, Ti₁₋ₓTaₓO₂ exhibits a tendency that the refractive index decreases in the wavelength range of **400**nm to **800**nm. The refractive index at a wavelength of **460**nm is about **2.5** where Ta is doped 3atom% to 5atom%. Here, the resistivity of Ti₁₋ₓTaₓO₂ where TiO₂ is doped with **3**atom% to **5**atom% Ta is **2x10**⁻³Ωcm or less. Therefore, in this embodiment, in order to ensure a refractive index difference from ITO as the second conductive layer **302** as well as a desired electrical conductivity, it is preferable to use Ti₁₋ₓTaₓO₂ doped with **3**atom% to **5**atom% Ta as the first conductive layer **300.**

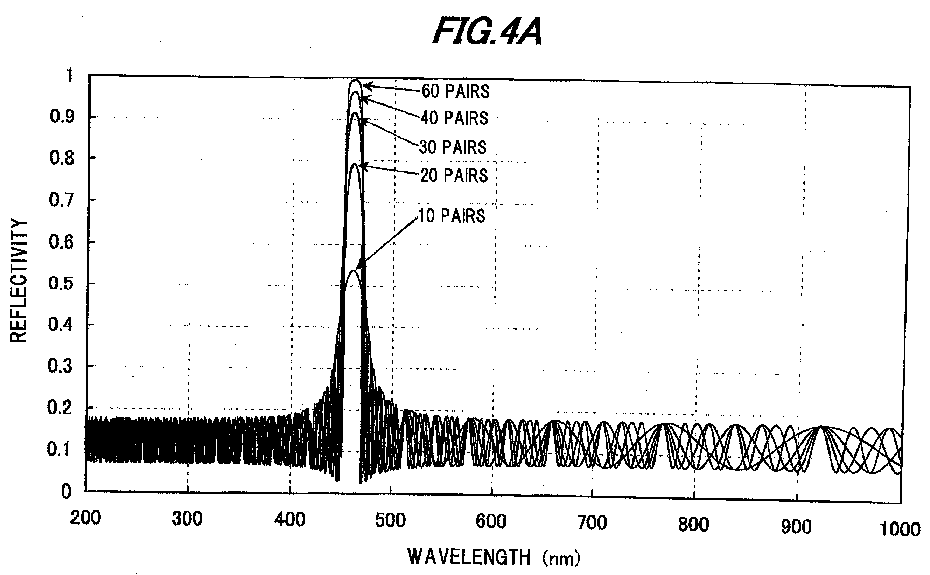

**FIG.4A** shows a reflectivity calculation result of a comparative example having a reflection layer composed of a material having a refractive index of **2.0** and a material having a refractive index of **2.1.**

In **FIG.4A****,** GaN **(2.45** in refractive index) is used as a light input medium and the air **(1.0** in refractive index) is used as a light output medium, and the thickness of ITO forming the conductive unit layer is set to be **57.5**nm and that of ZnO with a refractive index of **2.1** to be **54.8**nm such that wavelength for maximizing the refractive index comes to **460**nm. The reflectivity is calculated by varying the number of pairs of ITO and ZnO in the range **of 10** to **60.**

Referring to **FIG.4A****,** when the number of pairs is **40,** reflectivity at a wavelength of 460nm does not exceed **99%.** In contrast to this, when the number of pairs is **60,** although reflectivity at a wavelength of **460**nm exceeds **99%,** a wavelength range to keep a **99%** or more reflectivity is less than **10**nm. Therefore, in the conductive unit layer of ITO and ZnO, when a wavelength shift occurs in light emitted from the InGaN light-emitting layer **22,** it is difficult to keep the **99%** or more reflectivity. Also, when incident angle of light to the conductive reflection layer is large, it is difficult to keep the 99% or more reflectivity.

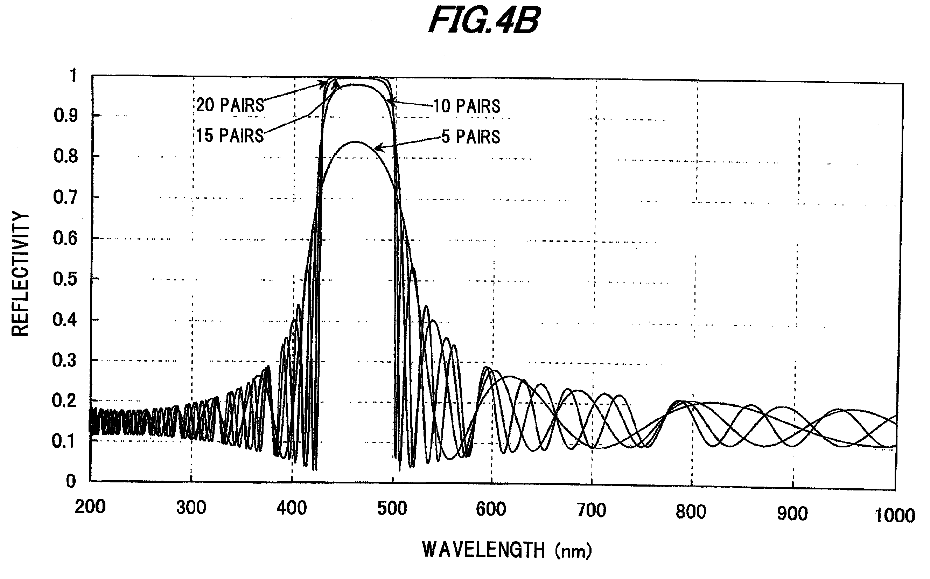

**FIG.4B** shows a reflectivity calculation result of an embodiment of the invention having the reflection layer composed of a material having a refractive index of **2.0** and a material having a refractive index of **2.5.**

In **FIG.4B****,** GaN **(2.45** in refractive index) is used as a light input medium and the air **(1.0** in refractive index) is used as a light output medium, and the thickness of ITO **(2.0** in refractive index) as the second conductive layer **302** forming the conductive unit layer **310** is set to be **57.5**nm **a**nd that of TiO₂ **(2.5** in refractive index) as the first conductive layer **300** to be **46.0**nm such that wavelength for maximizing the refractive index comes to **460**nm. The reflectivity is calculated by varying the number of pairs of ITO and TiO₂ in the range of **5** to **20.**

Referring to **FIG.4B****,** when the number of pairs of ITO and TiO₂ is more than **15,** reflectivity at a wavelength of **460**nm exceeds **99%** and becomes nearly **100%.** As a result, it is proved that at least **15** pairs of TiO₂ **(2.5** in refractive index) and ITO forming the conductive unit layer **310** can reflect nearly **100%** of light emitted from the InGaN light-emitting layer **22.**

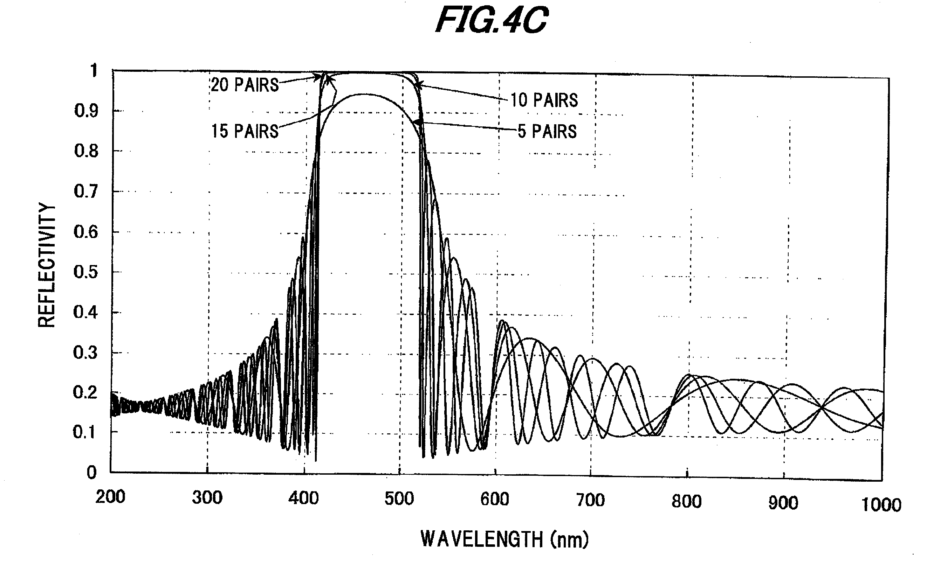

**FIG.4C** shows a reflectivity calculation result of an embodiment of the invention having the reflection layer of a material having a refractive index of **2.0** and a material having a refractive index **of 2.8.**

In **FIG.4C****,** GaN **(2.45** in refractive index) is used as a light input medium and the air **(1.0** in refractive index) is used as a light output medium, and the thickness of ITO **(2.0** in refractive index) as the second conductive layer **302** forming the conductive unit layer **310** is set to be **57.5nm** and that of TiO₂ **(2.8** in refractive index) as the first conductive layer **300** to be **41.1**nm such that wavelength for maximizing the refractive index comes to **460**nm. The reflectivity is calculated by varying the number of pairs of ITO and TiO₂ in the range of **5** to **20.**

Referring to **FIG.4C****,** when the number of pairs of ITO and TiO₂ is more than **10,** reflectivity at a wavelength of **460**nm exceeds **99%** and becomes nearly **100%.** As a result, it is found that at least **10** pairs of TiO₂ **(2.8** in refractive index) and ITO forming the conductive unit layer **310** can reflect nearly **100%** of light emitted from the InGaN light-emitting layer **22.**

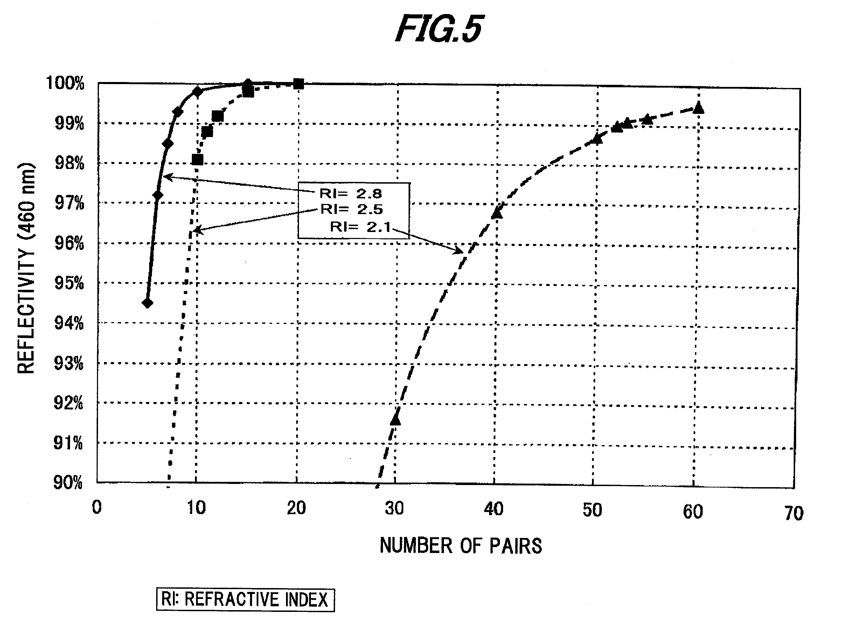

**FIG.5** shows a reflectivity dependency on the number of pairs of the conductive unit layer when using materials different in refractive index.

Specifically, **FIG.5** shows a reflectivity at a wavelength of **460**nm according to the number of pairs of conductive unit layer **310,** where a material for the second conductive layer **302** composing the conductive unit layer **310** is fixed ITO **(2.0** in refractive index), and a material for the first conductive layer **300** composing the conductive unit layer **310** is ZnO **(2.1** in refractive index), TiO₂ **(2.5** in refractive index) doped with impurity at a predetermined concentration, or TiO₂ **(2.8** in refractive index) doped with impurity at a predetermined concentration.

To obtain **99%** or more reflectivity at a wavelength of **460**nm, **53** pairs or more are required when the first conductive layer **300** is of ZnO. On the other hand, to obtain **99%** or more reflectivity at the wavelength of **460**nm, it is found that **12** pairs or more are enough when using TiO₂ having a reflectivity **of 2.5** as the first conductive layer **300,** and **8** pairs or more are enough when using TiO₂ having a reflectivity **of 2.8** as the first conductive layer **300.**

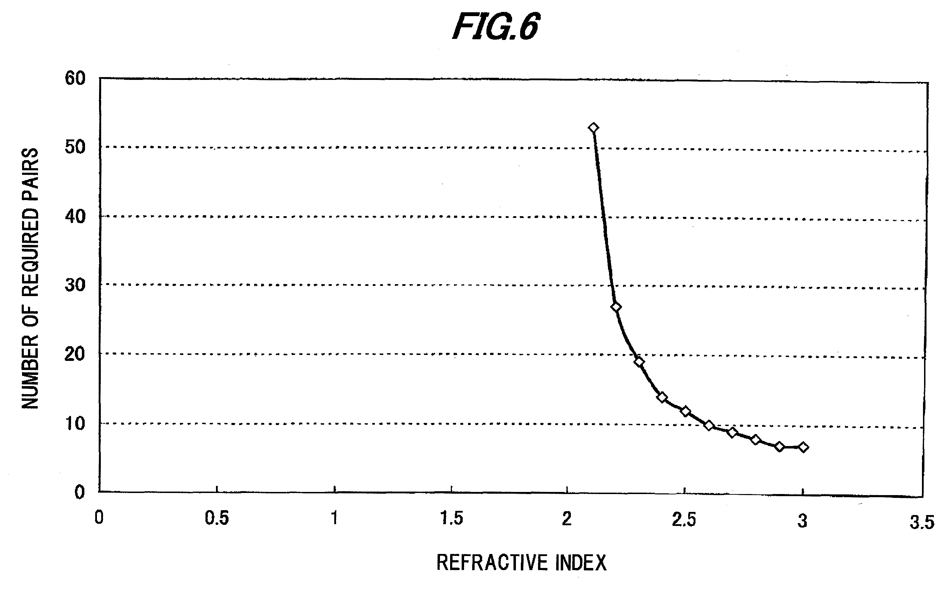

**FIG.6** shows the number of pairs of the conductive unit layer required when the second conductive layer is of ITO and so as to have **99%** or more reflectivity of the reflection layer at a wavelength of **460**nm.

Referring to **Fig.6**, it is found that, when the first conductive layer **300** is **2.3** or less in refractive index, the number of pairs of the conductive unit layer **310** increases abruptly that is required to have more than **99%** reflectivity of the reflection layer **30** at a wavelength of **460**nm. Therefore, it is found that the first conductive layer **300** is preferably **2.3** or more in refractive index.

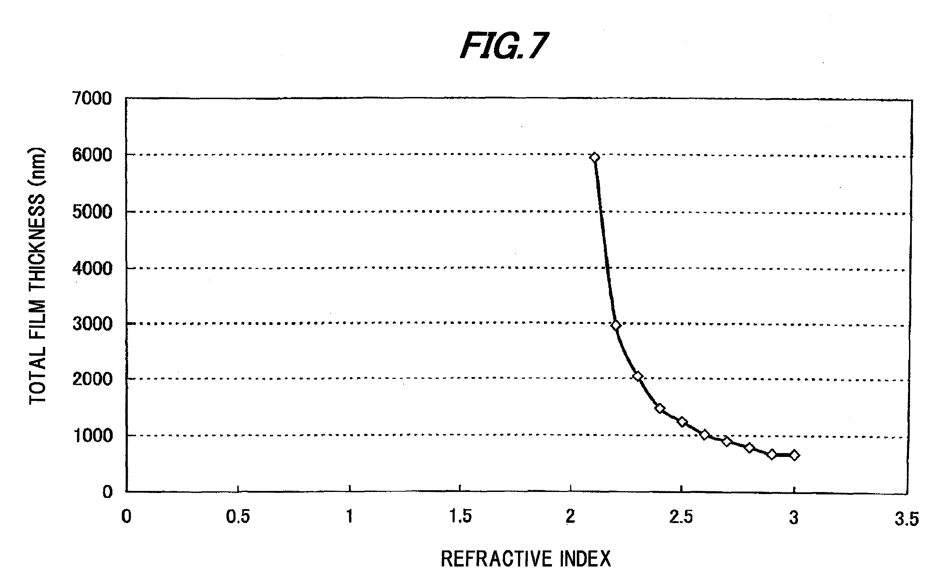

**FIG.7** shows a film thickness of the reflection layer composed of plural conductive unit layers when the second conductive layer is of ITO and so as to have **99%** or more reflectivity of the reflection layer at a wavelength of **460**nm.

Referring to **FIG.7**, it is found that, when the first conductive layer **300** is **2.3** or less in refractive index, the film thickness of the reflection layer **30** increases abruptly according as the number of pairs of the conductive unit layer **310** increases abruptly that is required to have more than **99%** reflectivity of the reflection layer **30** at a wavelength of **460**nm. According as the film thickness of the reflection layer **30** increases, resistance in thickness direction increases in accordance with increase in film thickness and the production cost also increases. Therefore, it is found that the first conductive layer **300** is preferably **2.3** or more in refractive index.

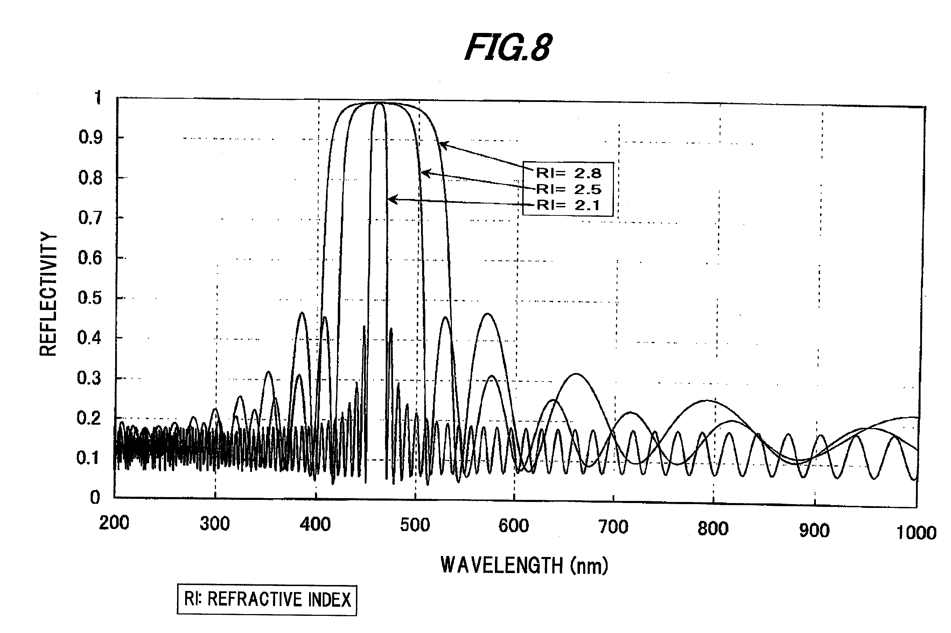

**FIG.8** shows a reflection spectrum when the reflection layer is provided with the number of pairs of the conductive unit layer required to have **99%** or more reflectivity of the reflection layer.

Referring to **FIG.8****,** reflectivity of the reflection layer **30** with respect to light with a wavelength of **460**nm exhibits about **99%** or more in each case that the refractive index of the first conductive layer **300** is **2.1, 2.5** or **2.8.** However, when the refractive index is **2.1,** a wavelength range is about **14**nm that the reflectivity of the reflection layer **30** exhibits about **90%** or more. On the other hand, when the refractive index is **2.5** or **2.8,** wavelength widths are about **68**nm and **104**nm, respectively, that the reflectivity of the reflection layer **30** exhibits about **90%** or more.

Therefore, even when a wavelength shift in light inputted to the reflection layer **30** occurs or light is obliquely inputted to the reflection layer **30,** it is possible to keep **90%** or more reflectivity with respect to a predetermined wavelength by using the first conductive layer **300 2.5** or **2.8** in refractive index.

### Effects of the first embodiment

The effects of the first embodiment are as follows.

In this embodiment, the reflection layer **30** is formed by laminating plural layers composed of TiO₂ which has electrical conductivity and refractive index of which can be controlled by a doping amount of Ta, and a material which has electrical conductivity and refractive index of which is smaller than that of TiO₂. Therefore, light emitted from the light-emitting layer can be reflected outside the light emitting device **1** by the formed reflection layer **30.** As a result, it is possible to efficiently extract light emitted from the light-emitting layer.

The light emitting device **1** in this embodiment allows the reflection layer **30** with electrical conductivity to be used as an electrode, and therefore it is not necessary to form another electrode separately from the reflection layer **30.** Therefore, it is possible to simplify the production process of the light emitting device **1.**

Although a conventional reflection layer is formed by laminating plurally ITO and ZnO layers having electrical conductivity, the refractive index difference between ITO and ZnO is small since ITO and ZnO are each around **2.0** in refractive index. Therefore, to obtain a desired reflectivity, for example, the number of laminated unit layers each composed of ITO and ZnO layers needs to be **50** to **60** where ITO and ZnO used are **2.0** and **2.1** in refractive index. In this embodiment, since the refractive index difference between TiO₂ (about **2.5)** forming the first conductive layer **300** and ITO (about **2.0)** forming the second conductive layer **302** is remarkably large compared to the conventional case, it is possible to significantly reduce the number of laminated unit layers each composed of the first conductive layer **300** and the second conductive layer **302.** As a result, it is possible to simplify the production process of the light emitting device **1** compared to the conventional case.

In this embodiment, the refractive index difference between the first conductive layer **300** and the second conductive layer **302** composing the reflection layer **30** is large. Thus, it is possible to have a wide reflection wavelength range of the reflection layer **30.** As a result, the reflection layer **30** can have a high reflectivity even under variation in emission wavelength of the InGaN light-emitting layer **22** and variation (due to the production process) in film thickness of the first conductive layer **300** and the second conductive layer **302.** Also, by the wide reflection wavelength range of the reflection layer **30,** the InGaN light-emitting layer **22** can be produced with a sufficient tolerance in emission wavelength when designing the quantum well structure thereof. Thus, freedom in designing the quantum well structure can be enhanced.

In this embodiment, the p-type electrode **40** may be formed on the reflection layer **30** as a metal layer for reflecting light emitted from the light-emitting layer. Since light passing through the reflection layer **30** can be reflected by the metal layer, it is possible to improve the efficiency for extracting light emitted from the light-emitting layer outside the light emitting device **1.**

Furthermore, since the refractive index of the first conductive layer **300** of TiO₂ can be changed by controlling the doping concentration of impurity, the reflection layer **30** can have a high reflectivity in a wide wavelength range including a desired wavelength.

### Modifications of the first embodiment

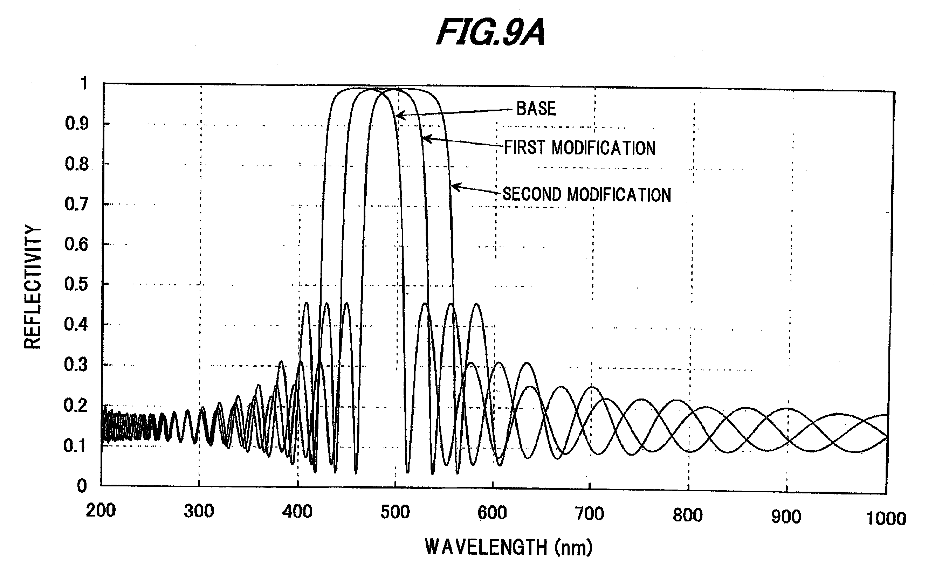

**FIG.9A** is a calculation result of reflectivity dependency on wavelength of the reflection layer in modifications of the first embodiment.

In the base reflection layer **30** in **FIG.9A****,** GaN **(2.45** in refractive index) is used as a light input medium, the air **(1.0** in refractive index) is used as a light output medium, and a wavelength to have a maximum refractive index (e.g., **99.2%)** is set to be **460**nm**.** For example, the thickness of ITO **(2.0** in refractive index) as the second conductive layer **302** forming the conductive unit layer **310** is set to be **57.5**nm and that of TiO₂ **(2.5** in refractive index) as the second conductive layer **302** to be **46.0**nm, and the reflection layer **30** formed by laminating **12** pairs of the unit layers each composed of the first conductive layer **300** and second conductive layer **302** is defined as the base reflection layer **30.** Namely, the film thickness of the reflection layer **30** is set to be **1/4**n of the wavelength, **460**nm (n is a refractive index).

In the reflection layer **30** of the first modification in **FIG.9A****,** GaN **(2.45** in refractive index) is used as a light input medium, the air **(1.0** in refractive index) is used as a light output medium. Specifically, the reflection layer **30** of the first modification is composed such that the number of pairs composed of ITO and TiO₂ is fixed to be **12** and the film thickness of the first conductive layer **300** and the second conductive layer **302** is set to be **1.05** times. Namely, the film thickness of the first conductive layer **300** of the reflection layer **30** in the first modification is set to be **48.3**nm and that of the second conductive layer **302** to be **60.4**nm. By this composition, reflectivity of the reflection layer **30** of the first modification is 97.8% to light with a wavelength of **460**nm.

In the reflection layer **30** of the second modification in **FIG.9A****,** GaN **(2.45** in refractive index) is used as a light input medium, the air **(1.0** in refractive index) is used as a light output medium. Specifically, the reflection layer **30** of the second modification is composed such that the number of pairs composed of ITO and TiO₂ is fixed to be **12** and the film thickness of the first conductive layer **300** and the second conductive layer **302** is set to be **1.1** times. Namely, the film thickness of the first conductive layer **300** of the reflection layer **30** in the second modification is set to be **50.6**nm and that of the second conductive layer **302** to be **63.3**nm. By this composition, reflectivity of the reflection layer **30** of the second modification is **6.0%** to light with a wavelength of **460**nm.

Referring to **FIG**.**9A**, the film thickness becomes thicker in the order of the base reflection layer **30,** the reflection layer **30** of the first modification and the reflection layer **30** of the second modification. As seen by referring to **FIG**.**9A**, the thicker the film thickness is, the longer the wavelength for maximizing the reflectivity is. Namely, a high reflection region of the reflection layer **30** shifts to the long-wavelength region as the film thickness of the reflection layer **30** becomes thicker.

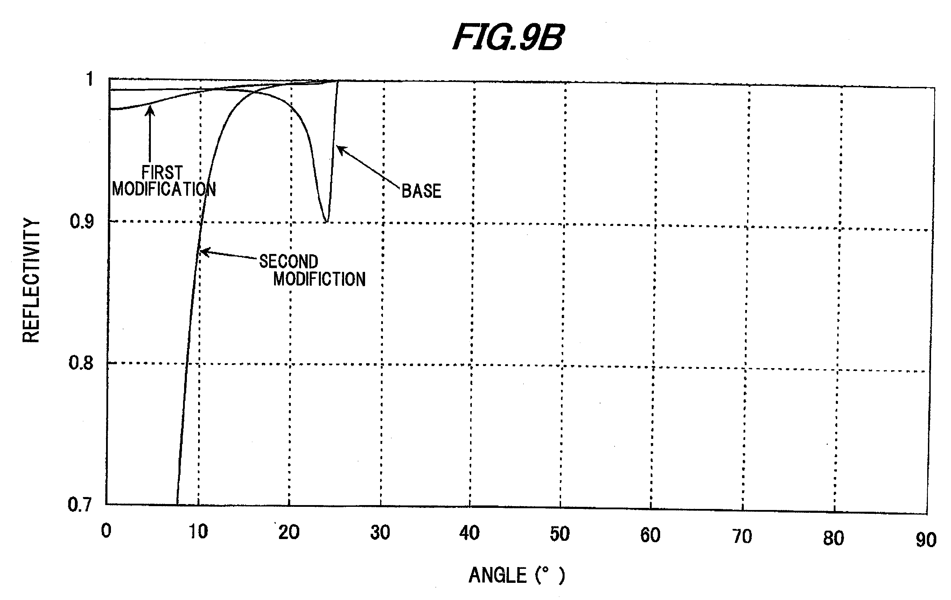

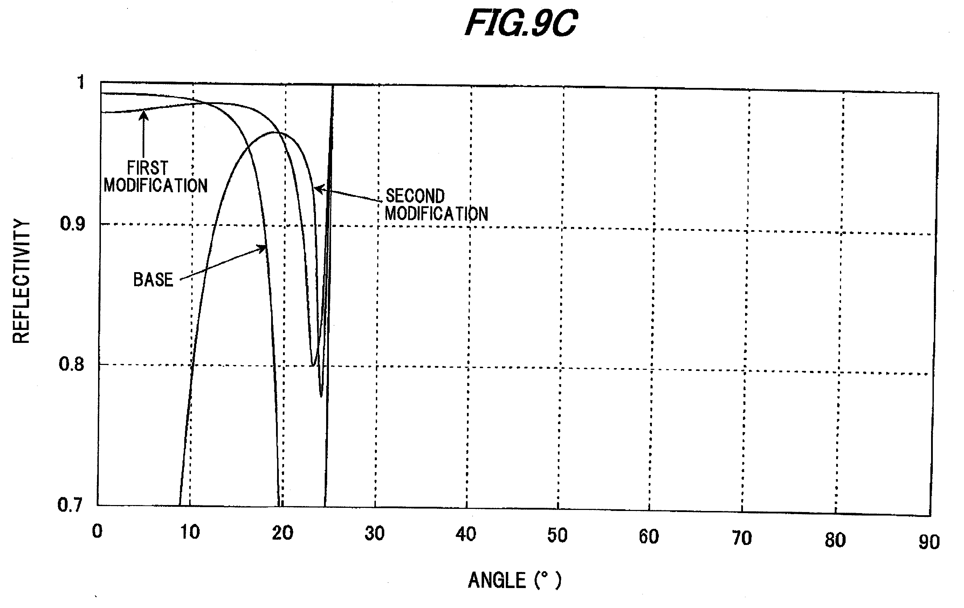

**FIG.9B** shows reflectivity dependency (S-wave) to light with a wavelength of **460**nm on incident angle of the reflection layer in the modifications, and **FIG.9C** shows reflectivity dependency (P-wave) to light with a wavelength of **460**nm on incident angle of the reflection layer in the modifications.

As seen by referring to **FIG.9B** and **FIG.9C****,** the reflection layer **30** of the first modification that the film thickness is **1.05** times thicker than the base reflection layer **30** exhibits high reflectivity with respect to light inputted at a incidence angle larger than the base reflection layer **30.** Namely, as shown in **FIG.9B****,** in the range of about **12°** to about **24°** of the incidence angle in S-wave, the reflection layer **30** of the first modification exhibits a reflectivity **of 95%** or more which is higher than that of the base reflection layer **30.** Furthermore, as shown in **FIG.9C****,** in the range of about **12°** to about **24°** of the incidence angle in P-wave, the reflection layer **30** of the first modification exhibits a reflectivity of **80%** or more which is higher than that of the base reflection layer **30.**

From the above results, it is found that it is preferable to set the respective film thickness of the first conductive layer **300** and the second conductive layer **302** composing the reflection layer **30** to be more than **1/4n** (n is a refractive index) of wavelength of light reflected by the reflection layer **30.** In particular, it is found that, by setting the respective film thickness of the first conductive layer **300** and second conductive layer **302** to be more than **1/4n** (n is a refractive index) of wavelength of light reflected by the reflection layer **30** and to be not more than **1.05** times of **1/4n** (n is a refractive index) of the wavelength of the light reflected in the reflection layer **30,** it is possible to reflect at a high reflectivity even light inputted to the reflection layer **30** at a large incident angle as well as ensuring the reflectivity for light inputted to the reflection layer **30** at a small incident angle.

As a result, even when predetermined light is obliquely inputted to the reflection layer **30,** it is possible to keep a high reflectivity by making the respective film thickness of the first conductive layer **300** and the second conductive layer **302** thicker than wavelength of light by a predetermined ratio, not only in case of light inputted to the reflection layer **30** at small incident angle (or vertically) but also in case of at large incident angle.

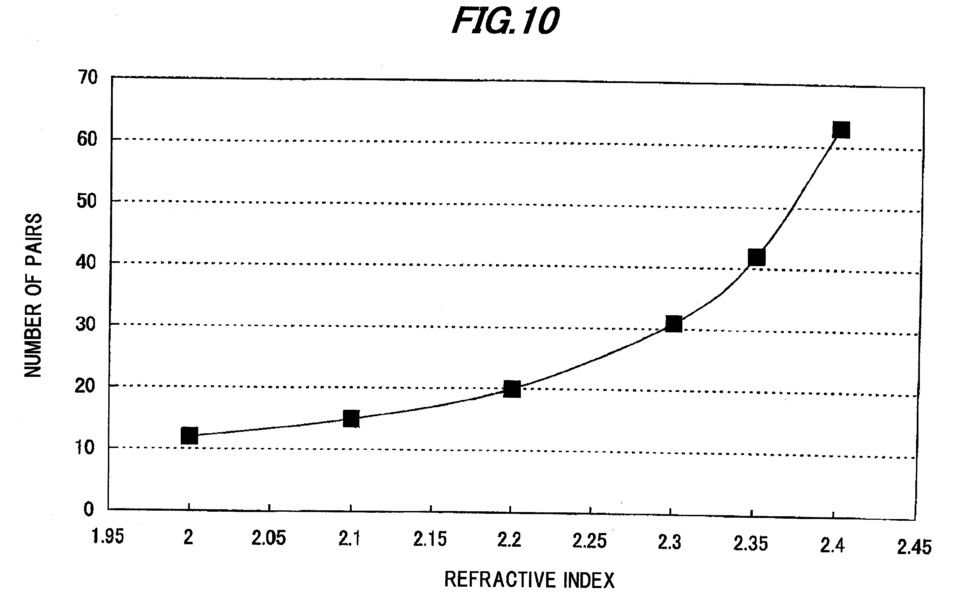

**FIG.10** shows the number of pairs of the conductive unit layer required for having a **99%** or more reflectivity of the reflection layer when the second conductive layer is changed in refractive index.

The first conductive layer **300** composing the reflection layer **30** is fixed to be TiO₂ **(2.5** in refractive index) and the second conductive layer **302** is varied **2.0** to **2.4** in refractive index. Here, the light input medium is GaN **(2.45** in refractive index), the light output medium is the air **(1.0** in refractive index), and the respective film thickness of the first conductive layer **300** and the second conductive layer **302** composing the reflection layer **30** is **460**nm/**4**n (n is a refractive index).

Referring to **FIG.10****,** when the refractive index of the second conductive layer **302** is more than **2.2,** the number of pairs of the conductive unit layer **310** increases abruptly. In contrast, when the refractive index of the second conductive layer **302** is not more than **2.2,** the reflectivity of the reflection layer **30** became **99%** or more and the number of required pairs of the conductive unit layer **310** is not more than **20.** As a result, considering the reflectivity of the reflection layer **30,** the refractive index of the second conductive layer is preferably not more than **2.2.**

### Second embodiment

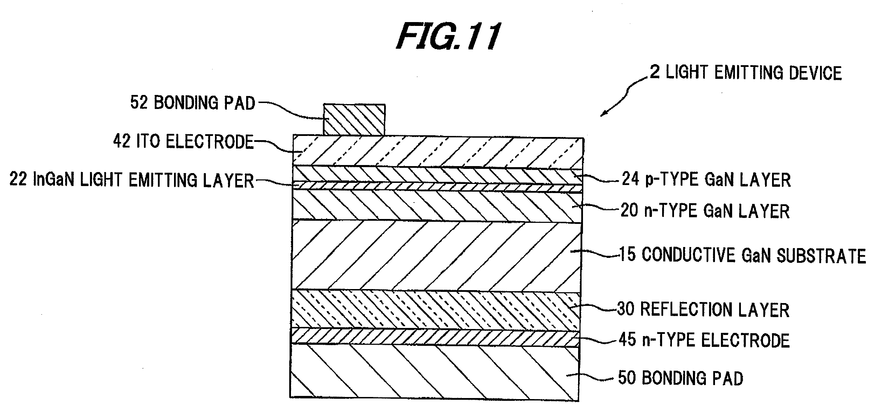

**FIG.11** shows a longitudinal sectional view of a light emitting device in a second preferred embodiment of the invention.

### Structure of light emitting device 2

A light emitting device **2** comprises a conductive GaN substrate **15,** a n-type GaN layer **20** formed on the conductive GaN substrate **15,** a InGaN light-emitting layer **22** formed on the n-type GaN layer **20** and a p-type GaN layer **24** formed on the InGaN light-emitting layer **22.**

The light emitting device **2** further comprises an ITO electrode **42,** a bonding pad **52** formed in a predetermined region on the ITO electrode **42,** the reflection layer **30** formed opposite the n-type GaN layer **20** in relation to a conductive GaN substrate **15,** the n-type electrode **45** formed on the side not contacting the conductive GaN substrate **15** of the reflection layer **30,** and a bonding pad **50** formed on the side not contacting the reflection layer **30** of the n-type electrode **45.** Here, as well as the bonding pad **50,** the bonding pad **52** is formed of a metal such as Ti, Ni and Au or the like.

The light emitting device **2** has the same compound semiconductor layers as the light emitting device **1** except that the compound semiconductor layers are formed not on the sapphire substrate **10** but on the conductive GaN substrate **15** which is different from the light emitting device **1.** Therefore, the detailed explanation of the compound semiconductor layers is omitted below. Also, the reflection layer **30,** the n-type electrode **45** and the bonding pad **50** of the light emitting device **2** have substantially the same composition, effects and functions as those of the light emitting device **1.** Therefore, the detailed explanation thereof is omitted below.

### Operation of light emitting device 2

When power is supplied to the InGaN light-emitting layer **22** through the bonding pad **52,** electric current flows between the ITO electrode **42** and the bonding pad **50** through the reflection layer **30.** The InGaN light-emitting layer **22** emits light at a predetermined wavelength by power supplied from the bonding pad **52.**

A part of light emitted from the InGaN light-emitting layer **22** is directly radiated outside the light emitting device **2** through the ITO electrode **42.** On the other hand, a part of light emitted from the InGaN light-emitting layer **22** is radiated toward the reflection layer **30** through the conductive GaN substrate **15.** The reflection layer **30** reflects a part of light emitted from the InGaN light-emitting layer **22** toward the ITO electrode **42.** Also, the n-type electrode **45** reflects a part of light passing through the reflection layer **30** toward the ITO electrode **42.**

### Effects of the second embodiment

According to the light emitting device **2** in this embodiment, the reflection layer **30** can be formed by laminating plurally the TiO₂ layer which has electrical conductivity and refractive index of which can be controllable by the amount of Ta doped and the other layer of a material having electrical conductivity and a refractive index smaller than TiO₂,and the face-up type LED can be formed by using the conductive GaN substrate **15.** As a result, light emitted from the light-emitting layer is reflected outside the light emitting device 2 by the reflection layer **30,** so as to improve the light extraction efficiency. Moreover, since the n-type and p-type electrodes are not needed to be formed both on the side of the p-type GaN layer **24** of the light emitting device **2,** the production process of the light emitting device **2** can be simplified and the device can be downsized.

Furthermore, according to the light emitting device **2** in this embodiment, the reflection layer **30** having electrical conductivity is formed on the conductive GaN substrate **15.** Therefore, it is possible to prevent the electrostatic breakdown of the light emitting device **2** as a current path is formed through the reflection layer **30** to outside of the light emitting device **2.**

### Third embodiment

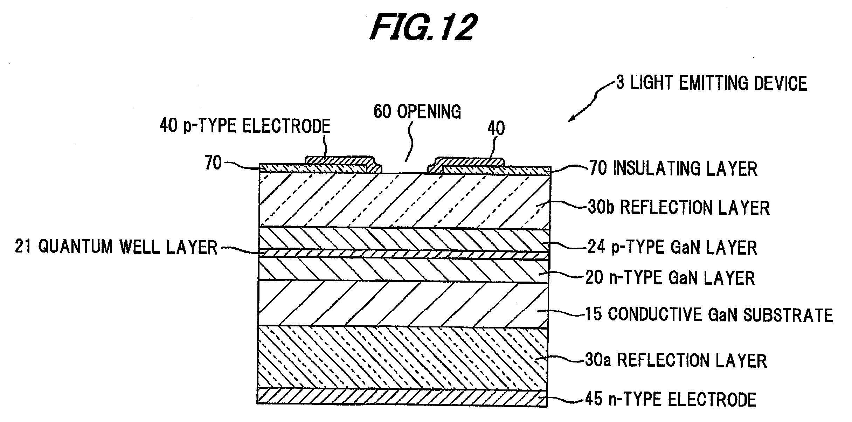

**FIG.12** shows a longitudinal sectional view of a light emitting device in the third preferred embodiment according to the invention.

### Structure of light emitting device 3

A light emitting device **3** comprises the conductive GaN substrate **15,** the n-type GaN layer **20** formed on the conductive GaN substrate **15,** a quantum well layer **21** formed on the n-type GaN layer **20,** and the p-type GaN layer **24** formed on the quantum well layer **21.** Since the n-type GaN layer **20** formed on the conductive GaN substrate **15,** the quantum well layer **21** and the p-type GaN layer **24** are formed by MOCVD in the same way as the light emitting device **1** as explained referring to **FIG.1** to **FIG.10**, the detailed explanation thereof is omitted below. Here, the quantum well layer **21** has a multiquantum well structure composed of InₓGa₁₋ₓN/GaN.

The light emitting device **3** further comprises a reflection layer **30b** formed on the p-type GaN layer **24,** an insulating layer **70** formed in a predetermined region on the reflection layer **30,** the p-type electrode **40** a part of which contacts the reflection layer **30b** and the other part of which not contacting the reflection layer **30b** is formed on the insulating layer **70,** a reflection layer **30a** formed contacting the conductive GaN substrate **15** opposite the n-type GaN layer **20** in relation to the conductive GaN substrate **15,** and the n-type electrode **45** formed on the side not contacting the conductive GaN substrate **15** of the reflection layer **30a.**

Here, although the reflection layers **30a** and **30b** have substantially the same composition as the reflection layer **30** as explained referring to **FIG.1** to **FIG.10**, they are formed such that the reflectivity of the reflection layer **30a** is higher than the reflection layer **30b.** Namely, the reflection layers **30a** and **30b** are formed by controlling the number of the conductive unit layers **310** included in the reflection layer **30a** and the number of the conductive unit layers **310** included in the reflection layer **30b.** Since the p-type electrode **40** and the n-type electrode **45** have substantially the same composition, effects and functions as the p-type electrode **40** and the n-type electrode **45,** respectively, as explained referring to **FIG.1** to **FIG.10**, the detailed explanation thereof is omitted below.

The insulating layer **70** is formed by, for example, vacuum deposition on the reflection layer **30b.** Specifically, the insulating layer **70** is formed of silicon dioxide (SiO₂). An opening **60** is formed for exposing a part of the reflection layer **30b** in the insulating layer **70.** The opening **60** is formed substantially circular (top view). Here, a part of the p-type electrode **40** is electrically connected to the reflection layer **30b** inside the opening **60.**

### Operation of light emitting device 3

The quantum well layer **21** emits light at a predetermined wavelength when receiving power supplied through the p-type electrode **40** and the reflection layer **30b.** Light emitted from the quantum well layer **21** is reflected by the reflection layer **30a** via the conductive GaN substrate **15.** Also, the reflection layer **30b** reflects light emitted form the quantum well layer **21** and light reflected by the reflection layer **30a.** As a result, light emitted form the quantum well layer **21** resonates between the reflection layers **30a** and **30b.** Namely, the light emitting device **3** of this embodiment is a Resonant-Cavity LED (RC-LED). In this case, by forming the reflection layers **30a** and **30b** such that the reflectivity of the reflection layer **30b** is smaller than that of the reflection layer **30a,** light resonated between the reflection layers **30a** and **30b** is radiated through the opening **60** outside the light emitting device **3.**

### Effects of the third embodiment

In the light emitting device **3** of this embodiment, since the Resonant-Cavity LED is composed of the reflection layers **30a** and **30b,** it is possible to improve the light extraction efficiency due to the angular selectivity and the photon recycling effect of the resonator.

### Fourth embodiment

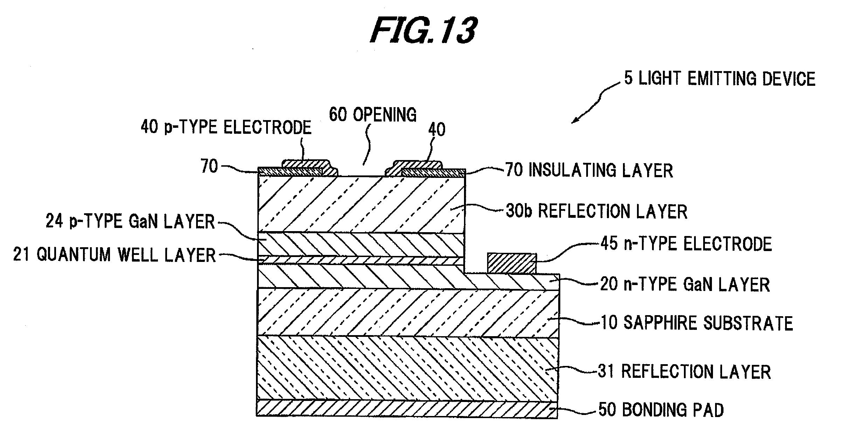

**FIG.13** shows a longitudinal sectional view of a light emitting device in the fourth preferred embodiment according to the invention.

A light emitting device **5** in this embodiment has substantially the same composition, effects and functions as the light emitting device **3** except that the conductive GaN substrate **15** of the light emitting device **3** in **FIG.12** is replaced with the sapphire substrate **10,** and that a reflection layer **31** is formed on the side not contacting the n-type GaN layer **20** of the sapphire substrate **10.** The detailed explanation on the same composition is omitted below.

In this embodiment, the quantum well layer **21** emits light at a predetermined wavelength when receiving power supplied through the p-type electrode **40** and the reflection layer **30**b. A part of light emitted from the quantum well layer **21** is reflected by the reflection layer **31** after passing though the sapphire substrate **10.** Light emitted form the quantum well layer 21 and light reflected by the reflection layer 31 are reflected by the reflection layer 30b. As a result, light emitted form the quantum well layer 21 resonates between the reflection layers 31 and 30b.

Here, the reflection layer 31 of this embodiment is not always needed to have electrical conductivity. For example, the reflection layer 31 is formed by laminating plural pairs composed of a first layer formed of TiO₂ without electrical conductivity and a second layer formed of SiO₂.Alternatively, the reflection layer 31 may be formed of the same material as the reflection layer 30a of the light emitting device 3.

### Fifth embodiment

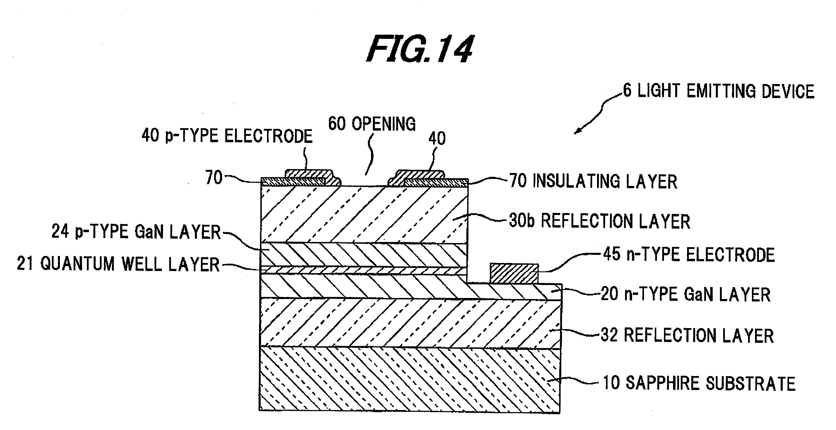

**FIG.14** shows a longitudinal sectional view of a light emitting device in the fifth preferred embodiment according to the present invention.

A light emitting device **6** in this embodiment has substantially the same composition, effects and functions as the light emitting device 3 except that the conductive GaN substrate **15** of the light emitting device **3** in **FIG.12** is replaced with the sapphire substrate **10,** that a reflection layer **32** is formed on the side of the n-type GaN layer **20** in relation to the sapphire substrate **10,** and that the n-type electrode **45** is formed on an exposed surface of the n-type GaN layer **20** which is located at a corner of the light emitting device **6** and formed by partially etching the reflection layer **30b,** the p-type GaN layer **24,** the quantum well layer **21** and a top portion of the n-type GaN layer **20.** The detailed explanation on the same composition is omitted below.

The light emitting device **6** in this embodiment comprises the sapphire substrate **10,** the reflection layer **32** formed of a nitride-based material formed on the sapphire substrate **10,** the n-type GaN layer **20** formed on the reflection layer **32,** the n-type electrode **45** formed partially on the n-type GaN layer **20,** the quantum well layer **21** formed at a region without the n-type electrode **45** of the n-type GaN layer **20,** the p-type GaN layer **24** formed on the quantum well layer **21,** and the reflection layer **30b** formed on the p-type GaN layer **24.**

The reflection layer **32** in this embodiment is, for example, formed by laminating plural nitride pairs of a first nitride layer of AlN and a second nitride layer of GaN. For example, it is possible to form the reflection layer **32** by laminating the **25** nitride pairs.

Although the invention has been described, the invention as recited by appended claims is not to be limited by the above embodiments. It should be noted that all combinations of the features as described in the embodiments are not always necessary to solve the problem of the invention.

A light emitting device includes a light-emitting layer for emitting light by being supplied with power, and a reflection layer for reflecting the light emitted from the light-emitting layer. The reflection layer has a first conductive layer of titanium oxide (TiO₂) including an impurity, electrical conductivity, and transparency to the light emitted from the light-emitting layer, and a second conductive layer of an electrically conductive material having a refractive index smaller than that of the first conductive layer, and transparency to the light emitted from the light-emitting layer, the second conductive layer contacting the first conductive layer. The power is supplied to the light-emitting layer through the first conductive layer and the second conductive layer.

## Claims

1. A light emitting device, comprising:
a light-emitting layer (22) for emitting light by being supplied with power; and
a reflection layer (30) for reflecting the light emitted from the light-emitting layer (22),
wherein the reflection layer (30) comprises:
a first conductive layer (300) comprising electrical conductivity, and transparency to the light emitted from the light-emitting layer (22); and
a second conductive layer (302) comprising an electrically conductive material having a refractive index smaller than that of the first conductive layer (300), and transparency to the light emitted from the light-emitting layer (22), the second conductive layer (302) contacting the first conductive layer (300),
wherein the power is supplied to the light-emitting layer (22) through the first conductive layer (300) and the second conductive layer (302), **characterized in that** the first conductive layer (300) comprises titanium oxide (TiO₂) including an impurity, the impurity comprises Ta in a predetermined doping amount to the first conductive layer (300),
wherein the first conductive layer (300) comprises Ti₁₋ₓTaₓO₂whose refractive index can be controlled according to the doping amount of Ta to the first conductive layer (300), wherein the refractive index of the first conductive layer (300) is in a range from 2.5 to 2.8 according to the doping amount of Ta to the first conductive layer (300),
wherein the difference between the refractive index of the first conductive layer (300) and that of the second conductive layer (302) is set to be from 0.5 to 0.8.

2. The light emitting device according to claim 1, wherein:
the reflection layer (30) comprises a structure in which a plurality of conductive unit layers comprising the first conductive layer (300) and the second conductive layer (302) contacting the first conductive layer (300) are stacked.

3. The light emitting device according to claim 2, wherein:
the first conductive layer (300) comprises a film thickness that is 1/(4n₁) of a wavelength of the light emitted from the light-emitting layer (22) where n₁ is a refractive index of the first conductive layer (300), and
the second conductive layer (302) comprises a film thickness that is 1/(4n₂) of the wavelength of the light emitted from the light-emitting layer (22) where n₂ is a refractive index of the second conductive layer (302).

4. The light emitting device according to claim 2, wherein:
the first conductive layer (300) comprises a film thickness that is greater than 1/(4n₁) of a wavelength of the light emitted from the light-emitting layer (22) where n₁ is a refractive index of the first conductive layer (300), and the second conductive layer (302) comprises a film thickness that is greater than 1/(4n₂) of the wavelength of the light emitted from the light-emitting layer (22) where n₂ is a refractive index of the second conductive layer (302).

5. The light emitting device according to claim 4, wherein:
the first conductive layer (300) comprises a film thickness that is not more than 1.05 times of 1/(4n₁) of the wavelength of the light emitted from the light-emitting layer (22), and
the second conductive layer (302) comprises a film thickness that is not more than 1.05 times of 1/(4n₂) of the wavelength of the light emitted from the light-emitting layer (22).

6. The light emitting device according to any one of claims 1 to 5, wherein:
the reflection layer (30) comprises a metal layer for reflecting the light emitted from the light-emitting layer (22) to an opposite side of the light-emitting layer (22).

7. The light emitting device according to any one of claims 1 to 6, wherein:
the electrically conductive material composing the second conductive layer (302) comprises a refractive index of not more than 2.2.

8. The light emitting device according to any one of claims 1 to 7, wherein:
the electrically conductive material composing the second conductive layer (302) comprises indium tin oxide (ITO).

9. The light emitting device according to any one of claims 1 to 6, wherein:
the electrically conductive material composing the second conductive layer (302) comprises zinc oxide (ZnO).

## Patentansprüche

1. Lichtemittierende Vorrichtung, mit:
einer Lichtemissionsschicht (22) zur Emission von Licht durch Zufuhr von Energie; und
einer Reflektionsschicht (30) zum Reflektieren des von der Lichtemissionsschicht (22) emittierten Lichtes,
wobei die Reflektionsschicht (30) aufweist:
eine erste Leitschicht (300), die eine elektrische Leitfähigkeit und eine Durchlässigkeit für das von der Lichtemissionsschicht (22) emittierte Licht aufweist; und
eine zweite Leitschicht (302), die ein elektrisch leitfähiges Material mit einem kleineren Brechungsindex als der der ersten Leitschicht (300) und einer Durchlässigkeit für das von der Lichtemissionsschicht (22) emittierte Licht aufweist, wobei die zweite Leitschicht (302) mit der ersten Leitschicht (300) in Kontakt steht,
wobei die Energie zu der Lichtemissionsschicht (22) durch die erste Leitschicht (300) und die zweite Leitschicht (302) zugeführt wird,
**dadurch gekennzeichnet, dass**
die erste Leitschicht (300) einen Dotierstoff beinhaltendes Titanoxid (TiO₂) aufweist, wobei der Dotierstoff Ta mit einem vorbestimmten Dotierstoffanteil an der ersten Leitschicht (300) aufweist,
wobei die erste Leitschicht (300) Ti₁₋ₓTaₓO₂ aufweist, dessen Brechungsindex entsprechend dem Ta-Dotierstoffanteil an der ersten Leitschicht (300) gesteuert werden kann,
wobei der Brechungsindex der ersten Leitschicht (300) in einem Bereich von 2,5 bis 2,8 entsprechend dem Ta-Dotierstoffanteil an der ersten Leitschicht (300) ist,
wobei die Differenz zwischen dem Brechungsindex der ersten Leitschicht (300) und dem der zweiten Leitschicht (302) auf 0,5 bis 0,8 eingestellt ist.

2. Lichtemittierende Vorrichtung nach Anspruch 1, wobei:
die Reflektionsschicht (30) eine Struktur aufweist, bei der eine Vielzahl von leitfähigen Einheitsschichten, die die erste Leitschicht (300) und die die erste Leitschicht (300) kontaktierende zweite Leitschicht (302) aufweisen, gestapelt sind.

3. Lichtemittierende Vorrichtung nach Anspruch 2, wobei:
die erste Leitschicht (300) eine Schichtdicke aufweist, die 1/(4n₁) von einer Wellenlänge des von der Lichtemissionsschicht (22) emittierten Lichtes ist, wobei n₁ ein Brechungsindex der ersten Leitschicht (300) ist, und
die zweite Leitschicht (302) eine Schichtdicke aufweist, die 1/(4n₂) von der Wellenlänge des von der Lichtemissionsschicht (22) emittierten Lichtes ist, wobei n₂ ein Brechungsindex der zweiten Leitschicht (302) ist.

4. Lichtemittierende Vorrichtung nach Anspruch 2, wobei:
die erste Leitschicht (300) eine Schichtdicke aufweist, die größer als 1/(4n₁) von einer Wellenlänge des von der Lichtemissionsschicht (22) emittierten Lichtes ist, wobei n₁ ein Brechungsindex der ersten Leitschicht (300) ist, und
die zweite Leitschicht (302) eine Schichtdicke aufweist, die größer als 1/(4n₂) von der Wellenlänge des von der Lichtemissionsschicht (22) emittierten Lichtes ist, wobei n₂ ein Brechungsindex der zweiten Leitschicht (302) ist.

5. Lichtemittierende Vorrichtung nach Anspruch 4, wobei:
die erste Leitschicht (300) eine Schichtdicke aufweist, die nicht gröβer als 1,05 mal 1/(4n₁) von der Wellenlänge des von der Lichtemissionsschicht (22) emittierten Lichtes ist, und
die zweite Leitschicht (302) eine Schichtdicke aufweist, die nicht gröβer als 1,05 mal 1/(4n₂) von der Wellenlänge des von der Lichtemissionsschicht (22) emittierten Lichtes ist.

6. Lichtemittierende Vorrichtung nach einem der Ansprüche 1 bis 5, wobei:
die Reflektionsschicht (30) eine Metallschicht zum Reflektieren des von der Lichtemissionsschicht (22) emittierten Lichtes zu einer der Lichtemissionsschicht (22) gegenüberliegenden Seite aufweist.

7. Lichtemittierende Vorrichtung nach einem der Ansprüche 1 bis 6, wobei:
das die zweite Leitschicht (302) ausbildende elektrisch leitfähige Material einen Brechungsindex von nicht mehr als 2,2 aufweist.

8. Lichtemittierende Vorrichtung nach einem der Ansprüche 1 bis 7, wobei:
das die zweite Leitschicht (302) ausbildende elektrisch leitfähige Material Indiumzinnoxid (ITO) aufweist.

9. Lichtemittierende Vorrichtung nach einem der Ansprüche 1 bis 6, wobei:
das die zweite Leitschicht (302) ausbildende elektrisch leitfähige Material Zinkoxid (ZnO) aufweist.

## Revendications

1. Dispositif électroluminescent, comprenant :
une couche luminescente (22) destinée à émettre de la lumière en étant alimentée par de l'électricité ; et
une couche réfléchissante (30) destinée à réfléchir la lumière émise par la couche luminescente (22),
dans lequel la couche réfléchissante (30) comprend :
une première couche conductrice (300) comprenant une conductivité électrique, et une transparence à la lumière émise par la couche luminescente (22) ; et
une deuxième couche conductrice (302) comprenant un matériau électriquement conducteur ayant un indice de réfraction inférieur à celui de la première couche conductrice (300), et une transparence à la lumière émise par la couche luminescente (22), la deuxième couche conductrice (302) étant en contact avec la première couche conductrice (300),
dans lequel l'électricité est fournie à la couche luminescente (22) par le biais de la première couche conductrice (300) et de la deuxième couche conductrice (302),
**caractérisé en ce que** la première couche conductrice (300) comprend de l'oxyde de titane (TiO₂) incluant une impureté, l'impureté comprenant du Ta en une quantité de dopage prédéterminée par rapport à la première couche conductrice (300),
dans lequel la première couche conductrice (300) comprend du Ti₁₋ₓTaₓO₂ dont l'indice de réfraction peut être contrôlé selon la quantité de dopage de Ta par rapport à la première couche conductrice (300),
dans lequel l'indice de réfraction de la première couche conductrice (300) est situé dans une plage de 2,5 à 2,8 selon la quantité de dopage de Ta par rapport à la première couche conductrice (300),
dans lequel la différence entre l'indice de réfraction de la première couche conductrice (300) et celle de la deuxième couche conductrice (302) est fixée pour se situer de 0,5 à 0,8.

2. Dispositif électroluminescent selon la revendication 1, dans lequel :
la couche réfléchissante (30) comprend une structure dans laquelle une pluralité de couches unitaires conductrices comprenant la première couche conductrice (300) et la deuxième couche conductrice (302) en contact avec la première couche conductrice (300) sont empilées.

3. Dispositif électroluminescent selon la revendication 2, dans lequel :
la première couche conductrice (300) comprend une épaisseur de film qui est de 1/(4n₁) d' une longueur d' onde de la lumière émise par la couche luminescente (22) où n₁ est un indice de réfraction de la première couche conductrice (300), et
la deuxième couche conductrice (302) comprend une épaisseur de film qui est de 1/(4n₂) de la longueur d'onde de la lumière émise par la couche luminescente (22) où n₂ est un indice de réfraction de la deuxième couche conductrice (302).

4. Dispositif électroluminescent selon la revendication 2, dans lequel :
la première couche conductrice (300) comprend une épaisseur de film qui est supérieure à 1/(4n₁) d'une longueur d'onde de la lumière émise par la couche luminescente (22) où n₁ est un indice de réfraction de la première couche conductrice (300), et
la deuxième couche conductrice (302) comprend une épaisseur de film qui est supérieure à 1/ (4n₂) de la longueur d'onde de la lumière émise par la couche luminescente (22) où n₂ est un indice de réfraction de la deuxième couche conductrice (302).

5. Dispositif électroluminescent selon la revendication 4, dans lequel :
la première couche conductrice (300) comprend une épaisseur de film qui n'est pas supérieure à 1,05 fois 1/(4n₁) de la longueur d'onde de la lumière émise par la couche luminescente (22), et
la deuxième couche conductrice (302) comprend une épaisseur de film qui n'est pas supérieure à 1,05 fois 1/(4n₂) de la longueur d'onde de la lumière émise par la couche luminescente (22).

6. Dispositif électroluminescent selon l'une quelconque des revendications 1 à 5, dans lequel :
la couche réfléchissante (30) comprend une couche métallique destinée à réfléchir la lumière émise par la couche luminescente (22) vers une face opposée de la couche luminescente (22).

7. Dispositif électroluminescent selon l'une quelconque des revendications 1 à 6, dans lequel :
le matériau électriquement conducteur composant la deuxième couche conductrice (302) comprend un indice de réfraction qui n'est pas supérieur à 2,2.

8. Dispositif électroluminescent selon l'une quelconque des revendications 1 à 7, dans lequel :
le matériau électriquement conducteur composant la deuxième couche conductrice (302) comprend de l'oxyde d'étain-indium (ITO).

9. Dispositif électroluminescent selon l'une quelconque des revendications 1 à 6, dans lequel :
le matériau électriquement conducteur composant la deuxième couche conductrice (302) comprend de l'oxyde de zinc (ZnO).
